Europäisches Patentamt

European Patent Office

Office européen des brevets

(19)

(11) Numéro de publication : **0 511 096 B1**

(12) **FASCICULE DE BREVET EUROPEEN**

(45) Date de publication du fascicule du brevet :
28.06.95 Bulletin 95/26

(51) Int. Cl.⁶ : **H01L 21/336,** H01L 29/78,
H01L 23/29

(21) Numéro de dépôt : **92401143.0**

(22) Date de dépôt : **22.04.92**

(54) Procédé de passivation locale d'un substrat par une couche de carbone amorphe hydrogène et procédé de fabrication de transistors en couches minces sur ce substrat passive.

(30) Priorité : **23.04.91 FR 9104994**

(43) Date de publication de la demande :
**28.10.92 Bulletin 92/44**

(45) Mention de la délivrance du brevet :
**28.06.95 Bulletin 95/26**

(84) Etats contractants désignés :
**DE GB NL**

(56) Documents cités :
**EP-A- 0 284 218**
**EP-A- 0 333 208**
**EP-A- 0 377 365**
**EP-A- 0 381 111**
**PATENT ABSTRACTS OF JAPAN vol. 11, no. 4 (E-468)7 Janvier 1987**
**IDR (INDUSTRIE DIAMANTEN RUNDSCHAU) vol. 18, no. 4, 1984, pages 249 - 253; B DISCHLER ET AL.: 'Eigenschaften und Anwendungen harter amorpher Kohlenstoffschichten'**

(56) Documents cités :
**THIN SOLID FILMS. vol. 136, no. 2, Février 1986, LAUSANNE CH pages 161 - 166; Z. HAS ET AL.: 'Electrical properties of thin carbon films obtained by R.F. methane decomposition on an R.F.-powered negatively self-biased electrode'**
**JOURNAL OF APPLIED PHYSICS. vol. 67, no. 8, 15 Avril 1990, NEW YORK US pages 3835 - 3841; W.J.VARHUE ET AL.: 'Electrical and chemical characterization of a-C:H prepared by rf glow discharge'**

(73) Titulaire : **FRANCE TELECOM**
**Etablissement autonome de droit public,**
**6, Place d'Alleray**
**F-75015 Paris (FR)**

(72) Inventeur : **Chouan, Yannick**
**1 Allée des Fougères**
**F-22700 Louannec (FR)**

(74) Mandataire : **Dubois-Chabert, Guy et al**
**c/o BREVATOME**
**25, rue de Ponthieu**
**F-75008 Paris (FR)**

EP 0 511 096 B1

## Description

La présente invention a pour objet un procédé de passivation locale d'un substrat par une couche mince de carbone amorphe hydrogéné. Elle trouve une application en microélectronique et en particulier dans la réalisation de circuits de commande des écrans plats à cristaux liquides.

L'invention permet plus spécifiquement la fabrication de transistors en couches minces à base de silicium amorphe hydrogéné, utilisés dans les écrans d'affichage à matrice active. En outre, l'invention permet de réaliser un transistor en couches minces à structure "planar" dans une configuration dite "empilée à grille dessus" semblable à celle utilisée dans les matrices actives pour écrans plats à cristaux liquides.

De façon générale, l'invention a pour objet un procédé de passivation locale d'un substrat par une couche mince de carbone amorphe hydrogéné.

Il est connu de déposer des couches minces de carbone amorphe hydrogéné, noté a-C:H, ou polycristallin sur des substrats de verre ou de silicium selon des techniques de dépôt chimique en phase vapeur assisté par plasma (PECVD). Le gaz utilisé pour le dépôt de carbone est essentiellement un mélange de méthane et d'hydrogène. On peut citer à cet effet, les articles suivants :
- "Electrical and chemical characterization of a-C:H prepared by RF Glow discharge" ; W.J. Varhue et al. - J. Appl. PHys. 67(8) - 15 avril 1990, p. 3835-3841 ;
- "Diamond and diamondlike films : Deposition processes and properties" ; C.V. Deshpandey et al., J.Vac. Sci. Technol. A7(3), mai/juin 1989, p. 2294-2302.

En raison de ses qualités mécaniques, le carbone amorphe hydrogéné, noté a-C:H, est actuellement principalement utilisé comme matériau de protection (composants optiques, outillage,...) mais ses qualités électriques permettent également d'envisager de l'utiliser comme diélectrique.

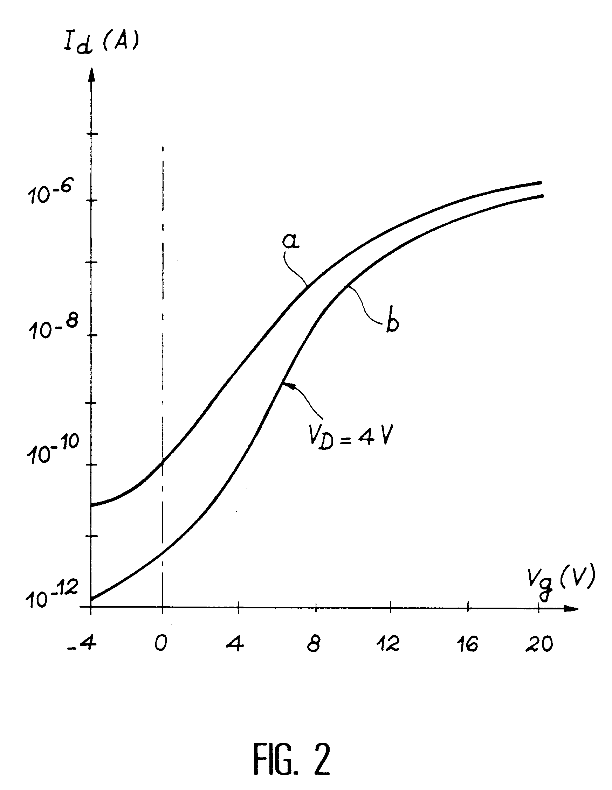

Le document Warhue ci-dessus enseigne (figures 2 et 11) l'obtention de couches de a-C:H de fortes résistivités ($10^{12}$ à $13^{13}$ohms.cm) en utilisant des pressions de gaz très faibles $\leqq$4Pa (30mTorrs) et des puissances radiofréquences de 10W. Dans ces conditions expérimentales, les couches de a-C:H sont fortement contraintes et adhèrent mal au substrat ; il y a risque de décollement des couches de 150 à 200nm.

La fabrication d'une matrice active pour écran plat à cristaux liquides à deux niveaux de masquage, comme décrit dans le brevet français FR-A-2 533 072, nécessite de graver une couche mince d'oxyde métallique, supportée par un substrat de verre afin de révéler les colonnes de la matrice. Cet oxyde est de l'oxyde d'indium et d'étain (ITO).

Cette gravure d'oxyde métallique s'effectue par voie humide en utilisant une solution contenant de l'acide chlorhydrique et du perchlorure de fer.

Les vitesses de gravure par voie humide sont généralement considérées comme isotropes à très courte distance. Toutefois, sur des substrats de grandes dimensions (>1dm$^2$), on observe un gradient de la vitesse de gravure entre les zones périphériques et le centre du substrat.

Les vitesses de gravure les plus élevées sont observées sur les bords du substrat.

De ce phénomène, il résulte que pour obtenir une gravure complète de la couche mince d'oxyde métallique il est nécessaire de surexposer les zones périphériques au bain de gravure.

On peut alors assister à une gravure partielle du verre et à la diffusion d'ions chlore dans son volume. La qualité de la surface du verre ainsi mise à nu se trouve donc altérée.

Les transistors en couches minces utilisés dans les écrans plats utilisent comme matériau semi-conducteur du silicium amorphe hydrogéné, noté a-Si:H. La structure de ces transistors conduit à déposer ce silicium directement sur le verre ; on observe alors une migration des ions chlore diffusés dans le verre. Cette migration des ions chlore ainsi que la qualité de l'interface verre/silicium amorphe modifient les propriétés semi-conductrices du silicium, entraînant une dégradation des propriétés électriques et une durée de vie limitée de ces transistors.

Le premier problème que cherche à résoudre l'invention est le contrôle de façon reproductible de la qualité de l'interface verre/silicium amorphe en proposant un procédé de passivation locale du substrat de verre. Ce problème existe depuis longtemps et n'a pas été résolu de façon satisfaisante jusqu'à ce jour.

Ces problèmes de contrôle de la qualité de l'interface substrat/semi-conducteur existent aussi pour d'autres types de substrat que le verre et pour d'autres matériaux semi-conducteurs que le silicium amorphe hydrogéné. Aussi, l'invention concerne toute passivation locale d'un substrat quelconque.

Dans le document EP-A-0 377 365, il est décrit une passivation locale d'un substat par un polymère déposé simultanément à l'érosion de motifs d'oxyde métallique utilisant un mélange particulier de trois gaz.

Cette technique d'érosion/dépôt conduit à des inhomogénéités d'épaisseur et de caractéristiques (mécaniques et électriques) dans la couche de polymère pour des surfaces de substrat $\geqq$1dm$^2$. Ainsi, cette technique n'est pas utilisable pour la réalisation d'écrans plats d'affichage de grandes dimensions.

On peut citer également le document Patent Abstract of JP-A-61 181 164 qui concerne la fabrication de transistors à effet de champ, à couches minces et où du nitrure de silicium est utilisé à des fins de passivation.

L'invention met en oeuvre une technique de pelage (technique lift-off en terminologie anglo-saxonne) dont le principe est connu de l'homme de l'art dans les domaines des couches minces et de la microélectronique. On peut citer à cet effet :

- Handbook of thin film technology by Leon I. Maissel and Reinhard Glang, Mc Graw - Hill Book Company, chapitre 7, pages 48-49. "Special pattern-formation techniques".

L'utilisation de cette technique permet, contrairement à l'art antérieur, l'obtention d'une couche de passivation en carbone amorphe hydrogéné, d'épaisseur et de caractéristiques mécaniques et électriques constantes sur une grande surface (>1dm$^2$). Ainsi, l'invention est parfaitement bien adaptée à la réalisation d'écrans plats de grandes dimensions.

Le procédé de l'invention permet l'obtention d'une couche de carbone amorphe hydrogéné présentant une résistivité comprise entre $10^{12}$ et $10^{14}$ohms/cm, ce qui assure une bonne isolation électrique. En particulier, ce dépôt local de carbone amorphe hydrogéné peut être interposé entre les sources et drains des transistors en couches minces à configuration "empilée à grille dessus". Aussi, ce procédé de passivation est particulièrement bien adapté à la réalisation d'un transistor en couches minces à configuration "empilée à grille dessus".

L'invention a donc pour objet un procédé de fabrication d'un transistor en couches minces, consistant à :

a) - déposer sur un substrat isolant électrique une couche d'un premier matériau conducteur,

b) - réaliser des motifs de résine photosensible sur la couche de premier matériau conducteur, définissant les motifs à graver dans cette couche,

c) - éliminer les zones de la couche de premier matériau conducteur non recouvertes de résine,

d) - déposer une couche de carbone amorphe hydrogéné sur la structure obtenue en c), ce dépôt étant effectué à une température suffisamment basse pour éviter une détérioration de ladite résine

e) - dissoudre les motifs de résine afin d'éliminer le carbone amorphe déposé sur la résine,

f) - déposer une couche d'un semi-conducteur sur la structure obtenue en e),

g) - déposer une couche d'un premier isolant électrique sur la couche de semi-conducteur,

h) - déposer une couche d'un second matériau conducteur sur la couche de premier isolant,

i) - photograver l'empilement des couches de second matériau conducteur, de premier isolant électrique et de semi-conducteur pour fixer les dimensions du transistor, et

j) - passiver la structure obtenue en i) avec un second isolant électrique.

Le procédé de l'invention est donc utilisable pour la fabrication d'écrans plats à matrice active selon la technique à deux niveaux de masquage et, grâce à la méthode de dépôt de a-C:H utilisée, il ne fait intervenir aucune étape de masquage supplémentaire.

Dans une structure à grille dessus, la couche de premier matériau conducteur est gravée pour former les source et drain du transistor alors que la couche de second matériau conducteur est gravée pour constituer la grille du transistor. Dans une structure à grille dessous, la couche de premier matériau conducteur est gravée pour constituer la grille du transistor alors que la couche de second matériau conducteur est gravée pour constituer la source et le drain du transistor.

Suivant la structure choisie et le mode d'éclairement choisi, les premier et second matériaux conducteurs peuvent être transparents ou réfléchissants.

De façon avantageuse, le second isolant électrique est du carbone amorphe hydrogéné.

Comme décrit précédemment, ces couches de a-C:H sont obtenues à partir d'un plasma radiofréquence constitué essentiellement d'hydrocarbure.

Par hydrocarbure, il faut comprendre des composés organiques constitués essentiellement de carbone et d'hydrogène.

Les hydrocarbures utilisables dans l'invention sont ceux de la série des alcanes, des alcènes et des alcynes que l'on trouve chez tous les producteurs de gaz fournissant l'industrie de la microélectronique. En particulier, ces hydrocarbures comportent de 1 à 6 atomes de carbone ; ils peuvent être saturés, insaturés ou aromatiques.

Comme hydrocarbures utilisables dans l'invention, on peut citer l'acéthylène, le propadiène, l'éthylène, le butène, le propylène, le méthane, l'éthane, le butane, le propane. De préférence, on utilise le méthane.

Selon l'invention, on peut utiliser un hydrocarbure ou un mélange d'hydrocarbures.

Les dépôts de carbone amorphe hydrogéné, selon l'invention, ont l'avantage d'être réalisés à température ambiante, ce qui permet d'éviter une élévation excessive de la température de la résine utilisée pour le pelage et donc une détérioration de celle-ci.

Afin d'obtenir une structure de transistor "planar", l'épaisseur de la couche de carbone amorphe hydrogéné déposée au cours de l'étape d) a une épaisseur égale à celle de la couche de premier matériau conducteur. Ceci est plus particulièrement intéressant lorsque cette couche de premier matériau conducteur est utilisée pour la fabrication des contacts de source et drain du transistor.

En ajustant les conditions de tension d'autopolarisation du substrat, de la pression et du débit du gaz, les inventeurs ont montré qu'il était possible de faire varier le taux de dissociation de l'hydrocarbure et en particulier du méthane dans le plasma. Suivant le taux de dissociation de l'hydrocarbure, les films polymériques obtenus sont plus ou moins hydrogénés, ce qui leur confère des propriétés physiques très différentes, notamment en ce qui concerne leur résistivité. Il est ainsi possible de moduler les propriétés de la couche de carbone déposée en fonction de l'application particulière envisagée.

D'autres caractéristiques et avantages de l'invention ressortiront mieux de la description qui va suivre, donnée à titre illustratif et non limitatif. Cette description sera faite dans le cadre de la fabrication d'un transistor en couches minces à grille dessus mais bien entendu, l'invention est d'application beaucoup plus générale comme on l'a vu précédemment.

La description se réfère aux dessins annexés dans lesquels :
- les figures 1a à 1f illustrent schématiquement les différentes étapes de fabrication d'un transistor en couches minces, conformément à l'invention, et
- la figure 2 donne les variations du courant de drain Id, exprimée en ampères, en fonction de la tension de grille Vg, exprimée en volts, pour un transistor témoin non passivé (courbe a) et pour un transistor passivé selon l'invention (courbe b).

Le dépôt des couches minces de carbone amorphe hydrogéné selon l'invention est réalisé à l'aide d'un réacteur du type RIE classiquement utilisé en microélectronique. Le substrat devant recevoir le dépôt est, de ce fait, disposé sur une électrode reliée à un générateur radiofréquence ; le dépôt réalisé est donc de type ionique. On utilise en général une fréquence de 13,56 MHz.

Dans tous les essais expérimentaux réalisés, on a utilisé pour créer le plasma du méthane pur. En outre, les dépôts ont été réalisés à température ambiante.

Différentes conditions expérimentales ont été étudiées pour le dépôt des couches minces de carbone amorphe hydrogéné. Ces conditions sont les suivantes :
- pression du méthane : 1,33 à 20Pa (10 à 150 mTorrs).
- débit du méthane : 5 à 50 $cm^3$/min.
- tension d'autopolarisation du substrat : 10 à 300 V.
- puissance RF : 10 à 280 W.

Dans ces conditions, les films obtenus permettent de réaliser les fonctions de passivation d'un substrat et de "planarisation" des transistors faisant l'objet de l'invention.

Plus précisément, les films de carbone obtenus possèdent les caractéristiques suivantes :
1) - épaisseur $\leqq$ 200 nm,
2) - forte résistivité,
3) - parfait état de surface,
4) - faible contrainte mécanique,
5) - propriétés homogénes sur de grandes surfaces (>1$dm^2$).

1) - Epaisseur

Dans le but de réaliser une simple passivation d'un substrat de verre, un dépôt de polymère de quelques 10 nm est suffisant.

En revanche, pour réaliser une "planarisation" parfaite du transistor notamment entre la source et le drain, il est nécessaire de déposer un film de 200 nm d'épaisseur correspondant à l'épaisseur de la couche conductrice utilisée pour les source et drain.

Ces deux types de dépôt ont été réalisés avec succès et à des vitesses de dépôt comprises entre 1,5 nm et 20 nm par minute.

2) - Résistivité

Pour éviter tout risque de court-circuit entre notamment la source et le drain du transistor (ou entre les grilles d'une matrice de transistors à grille dessous), le polymère déposé doit présenter une forte résistivité. Or, les films de carbone amorphe hydrogéné réalisés possèdent tous une résistivité comprise entre $10^{12}$ et $10^{14}$ ohms.cm.

Les inventeurs ont démontré que ces valeurs sont suffisamment élevées pour éviter tout risque de court-circuit entre source et drain (ou grilles).

3) - Contrainte

Ces films doivent naturellement présenter une bonne adhérence sur le substrat généralement de verre mais aussi être faiblement contraint pour éviter :
- un "écaillage" sur la surface de la résine,
- un décollement de l'empilement des couches constituant le transistor.

Les mesures effectuées (flèche d'un substrat mince) montrent que les films sont contraints en compression à des valeurs comparables à celles mesurées usuellement pour d'autres matériaux déposés en couches minces.

Les valeurs des contraintes les plus faibles, pour une épaisseur donnée de film de a-C:H sont obtenues pour les puissances RF les plus faibles et pour les plus fortes pressions gazeuses comme cela ressort clairement du tableau I, ci-après.

Ce tableau I est relatif à des films de 90nm déposés avec du $CH_4$ pur à un débit de 20cm$^3$/min. Les valeurs des contraintes sont données en 10$^9$Pa (soit 10$^{10}$dyne/cm$^2$).

## T A B L E A U   I

| Pression/Puissance | | 10W | 50W | 200W |
|---|---|---|---|---|
| 1,33Pa | (10mTorrs) | – | 34 | – |
| 7,7Pa | (58mTorrs) | – | 13 | - |
| 13,3Pa | (100mTorrs) | <9 | 9 | 20 |

Dans le tableau II, ci-après, on donne les épaisseurs limites des films de a-C:H avant leur décollement d'un substrat de verre. Ces films sont déposés avec du $CH_4$ pur à un débit de 20cm$^3$/min et une pression de 13,3 Pa (100mTorrs).

## T A B L E A U   II

| EPAISSEUR LIMITE (nm) | 420 | 320 | 170 | 130 | 100 |
|---|---|---|---|---|---|
| PUISSANCE (W) | 20 | 50 | 200 | 400 | 600 |

On constate que la limite d'épaisseur des films décroît quand la puissance RF croît, toute chose égale par ailleurs.

Par ailleurs, les épaisseurs limites des films sont toujours inférieures à 100nm pour des pressions de 2,66Pa à 4Pa (20 à 30mTorrs).

Les conditions optimum de dépôt de a-C:H pour une faible contrainte et une forte résistivité sont les suivantes :
- pression : 6,6Pa à 20Pa (50 à 150mTorrs) et typiquement 13,3Pa (100mTorrs),
- débit de méthane : 10 à 50cm$^3$/min et typiquement 20cm$^3$/min,
- puissance RF : 10 à 100W et typiquement 50W,
- tension d'autopolarisation : 10 à 300V et typiquement 10 à 55V.

4) - Etat de surface

Dans le réacteur utilisé, le substrat est maintenu à température ambiante pour obtenir le dépôt de films parfaitement amorphes, (l'état amorphe des films ayant été déterminé par diffraction des rayons X). Une analyse topographique de la surface des films au microscope électronique à balayage jusqu'à des grossissements de 30000 ne permet pas de révéler un quelconque défaut de surface intrinsèque au matériau déposé.

La qualité de l'interface entre le carbone amorphe hydrogéné et les couches constituant le transistor ne pourra donc pas être altérée pour des raisons de rugosité.

## 5) - Grande surface

L'homogénéité des propriétés des films déposés a été vérifiée sur des substrats carrés de 20cm de côté.

Les substrats sur lesquels peut être réalisé le dépôt de carbone amorphe hydrogéné local peuvent être en verre, en quartz, en silice, en silicium, en plastique. En outre, la passivation de ces substrats permet d'utiliser des substrats de verre de qualité médiocre, par exemple du type "sadocalcique", et donc de faible coût réduisant ainsi, dans le cadre de la fabrication d'écrans plats, le coût de ces derniers.

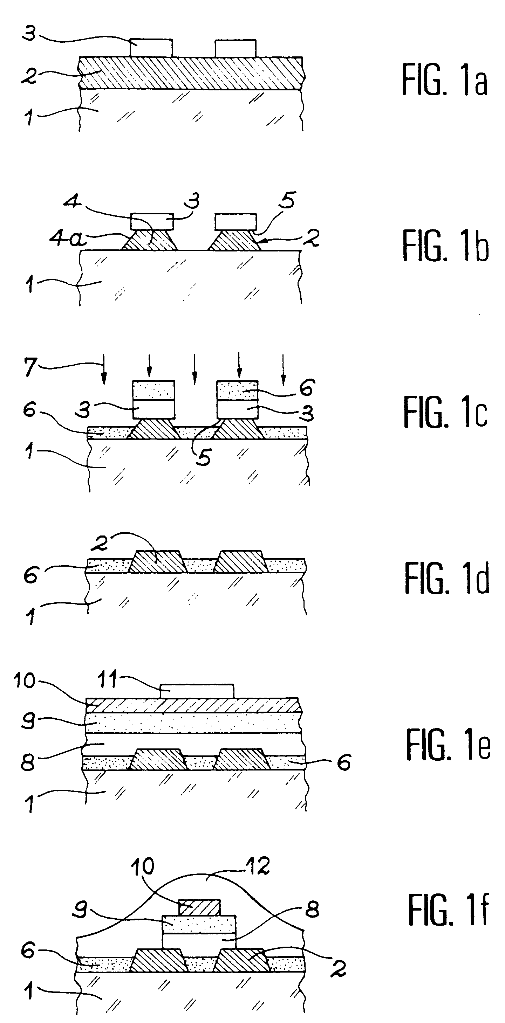

En référence aux figures 1a à 1f, on décrit ci-après les principales étapes de fabrication d'un transistor en couches minces à grille dessus, conformément à l'invention.

La première étape de fabrication de ce transistor consiste, comme représenté sur la figure 1a, à déposer sur un substrat de verre 1 une couche 2 d'oxyde métallique transparent de 25 à 225nm d'épaisseur. Cette couche est de l'oxyde d'indium et d'étain (ITO) déposée par pulvérisation magnétron sous vide.

Sur cette couche d'ITO on forme un premier masque de résine photosensible 3 définissant l'emplacement de la source et du drain du transistor à réaliser selon les procédés classiques de photolithographie.

On effectue alors, comme représenté sur la figure 1b, une gravure de la couche d'oxyde métallique 2 par spray ou dans un bain d'acide chlorhydrique. La gravure est contrôlée en ce qui concerne la concentration de l'agent de gravure, de la température et du temps de gravure afin d'obtenir des motifs 4 d'ITO à flancs 4a inclinés. En particulier, cette gravure est réalisée avec un bain contenant 37% d'acide chlorhydrique dilué à 50% dans de l'eau et porté à une température de 55°C environ.

Ces flancs inclinés 4a des motifs 4 permettent de dégager un liseré 5 de résine à l'interface ITO/résine.

Les motifs 4 obtenus constituent la source et le drain du transistor.

On effectue alors, comme représenté sur la figure 1c, un dépôt isotrope à température ambiante d'une couche de carbone amorphe hydrogéné 6 sur l'ensemble de la structure. Cette couche 6 a une épaisseur de 10 à 150nm. Elle est réalisée dans les conditions optimum décrites précédemment, en utilisant un plasma radiofréquence 7 de $CH_4$.

L'isotropie du dépôt conduit à la formation d'une couche de carbone 6 discontinue. On conserve ainsi le liseré 5 apparent, sous les motifs 3 de résine.

Le pelage de la couche de carbone s'effectue sans difficulté par dissolution de la résine 3, à partir du liseré 5, en utilisant de l'acétone ou un dissolvant classiquement utilisé en microélectronique appelé "posistrip".

Seul le carbone 6 déposé sur le verre 1 est conservé, comme montré sur la figure 1d. On obtient ainsi une passivation locale du substrat en verre 1 qui joue le rôle de barrière à la diffusion des impuretés contenues dans le verre vers la couche semi-conductrice du transistor que l'on va maintenant déposer. Ces impuretés proviennent notamment de la gravure de l'ITO.

La fabrication du transistor se poursuit, comme représenté sur la figure 1e, par le dépôt, sur l'ensemble de la structure, d'une couche de silicium amorphe hydrogéné 8, d'une couche de nitrure de silicium 9 puis d'une couche métallique 10 en aluminium ou siliciure d'aluminium.

Les couches 8 et 9 sont déposées selon la technique de dépôt chimique en phase vapeur assisté plasma et la couche métallique est déposée par évaporation ou pulvérisation. Ces couches 8, 9 et 10 ont une épaisseur respective de 20nm, 300nm et 200nm.

On définit alors les dimensions du transistor à l'aide d'un second photomasque en résine 11 réalisé par les procédés connus de photolithographie.

On effectue alors une gravure par voie humide de la couche 10 puis une gravure anisotrope par voie sèche des couches 9 et 8. Les agents d'attaque sont respectivement un plasma de $SF_6$ pour les couches 8 et 9 et un bain d'acide orthophosphorique pour la couche 10.

Après élimination du photomasque en résine 11 par voie humide, il est éventuellement possible de former un autre photomasque, non représenté, définissant les dimensions de la grille du transistor dans la couche 10. A l'aide de ce photomasque, on effectue alors une nouvelle gravure humide de la couche conductrice 10 pour former la grille du transistor. Après élimination de ce photomasque, on passive l'ensemble de la structure par dépôt d'une nouvelle couche 12 de carbone amorphe hydrogéné ou d'une couche de nitrure de silicium. La structure obtenue est celle représentée sur la figure 1f.

La couche 12 de carbone est déposée en utilisant un plasma RF de $CH_4$ et la couche de nitrure de silicium par dépôt chimique en phase vapeur assisté plasma.

On constate que ce procédé de passivation du substrat et de "planarisation" des source et drain du transistor ne nécessite pas de niveau de masquage supplémentaire par rapport aux procédés connus de fabrication de ces transistors.

Le procédé décrit en référence aux figures la à 1f est compatible avec le procédé de fabrication d'un écran d'affichage à matrice active décrit dans le document FR-A-2 571 893.

Le procédé de dépôt d'une couche mince de carbone amorphe hydrogéné et de son pelage a été appliqué à la fabrication de transistors à effets de champ pour commande d'écrans plats à cristaux liquides.

Différents essais de passivation et de "planarisation" ont été réalisés en fonction de la quantité d'hydrogène contenue dans les films de carbone. La concentration d'hydrogène contenue dans les films n'est pas connue en valeur absolue, toutefois, elle peut être modifiée de façon simple en ajustant le taux de dissociation du méthane par le contrôle de la tension d'autopolarisation du substrat.

En particulier, les inventeurs ont montré, par mesure de résistivité, d'absorption optique et par analyse SIMS, que les films de carbone déposés avec les tensions d'autopolarisation les plus faibles contiennent le plus d'hydrogène.

Le tableau III donné ci-après montre clairement l'efficacité de la passivation du substrat de verre mais aussi l'influence de la qualité du film de passivation sur les caractéristiques électriques des transistors.

Les dépôts de carbone ont été réalisés sous une pression de 13,3 Pa (100 mtorr) et pour un débit de $CH_4$ de $20cm^3/min$. La puissance radio était de 50W. La tension de drain était de 0,1 V et la tension de grille de 8V.

Ce tableau donne notamment l'évolution du rapport des courants de drain dans l'état passant (Ion) et bloqué (Ioff) en fonction de la nature des films de passivation déposés à différentes tensions d'autopolarisation.

D'après ce tableau, on constate que le rapport des courants Ion/Ioff croît rapidement avec la concentration d'hydrogène contenue dans les couches de passivation. Le rapport de ces courants est 25 fois supérieur dans le cas d'un transistor réalisé avec une passivation déposée avec une tension d'autopolarisation de 10V, par rapport à un transistor réalisé directement sur le substrat de verre.

Il est connu de l'homme de l'art que les principales propriétés que doit avoir le transistor de commande de chaque élément d'image d'un écran plat sont :
- dans la phase d'adressage un courant Ion entre source et drain aussi fort que possible afin de pouvoir charger le condensateur à cristal liquide aussi rapidement que possible à la tension vidéo,
- dans la phase de maintien de l'information, un courant Ioff aussi faible que possible de façon qu'entre deux adressages successifs, le condensateur reste chargé.

Aussi, le rapport Ion/Ioff doit être au moins égal à $10^5$ pour pouvoir faire fonctionner un écran plat comportant quelques centaines de lignes.

Cet objectif est atteint pour des films de carbone amorphe hydrogéné de passivation locale, déposés à des tensions d'autopolarisation inférieures à 55 volts.

La figure 2 donne les caractéristiques de transfert Id=f(Vg) pour un transistor témoin non passivé (courbe a), et pour un transistor passivé (courbe b) entre source et drain par une couche de carbone amorphe hydrogéné, déposée avec une tension d'autopolarisation de 40 volts dans les conditions optimum ci-dessus. Id est le courant de drain, en ampères et Vg la tension en volts appliquée à la grille du transistor. Ces courbes sont obtenues pour une tension de drain de 4 volts, une largeur de canal de 10μm et une longueur de canal de 40μm.

En plus des avantages donnés ci-dessus, le carbone amorphe hydrogéné déposé entre les source et drain du transistor joue le rôle de masque optique limitant ainsi les effets néfastes de la lumière ambiante d'observation de l'écran sur le silicium amorphe hydrogéné.

Sur les figures 1c à 1f, on a représenté une couche 6 de carbone amorphe hydrogéné d'épaisseur légèrement inférieure à celle des motifs 4 des source et drain du transistor. Il est toutefois possible, comme mentionné précédemment, de déposer une couche 6 d'épaisseur rigoureusement égale à celle des motifs 4 des source et drain afin d'obtenir une structure parfaitement plane avant le dépôt de la couche semi-conductrice 8.

EP 0 511 096 B1

<u>T A B L E A U   III</u>

| TENSION AUTO-POLARISATION | Ion (µA) | Ioff(pA) | $\dfrac{Ion}{Ioff}$ | CONCENTRATION HYDROGENE |
|---|---|---|---|---|
| 10 | 1,6 | 1,6 | $10^6$ | |
| 55 | 2,6 | 12 | $2.10^5$ | |
| 90 | 3,4 | 39 | $9.10^4$ | CROISSANTE ↑ |
| 160 | 3,1 | 39 | $8.10^4$ | |
| 290 | 3,7 | 79 | $5.10^4$ | |
| TEMOIN | 2,6 | 73 | $4.10^4$ | |

**Revendications**

1. Procédé de fabrication d'un transistor en couches minces, consistant à :

   a) - déposer sur un substrat isolant électrique (1) une couche (2) d'un premier matériau conducteur,

   b) - réaliser des motifs (3) de résine photosensible sur la couche de premier matériau conducteur, définissant les motifs à graver dans cette couche,

   c) - éliminer les zones de la couche de premier matériau conducteur non recouvertes de résine,

   d) - déposer une couche (6) de carbone amorphe hydrogéné sur la structure obtenue en c), ce dépôt étant effectué à une température suffisamment basse pour éviter une détérioration de ladite résine,

   e) - dissoudre les motifs de résine afin d'éliminer le carbone amorphe déposé sur la résine,

   f) - déposer une couche (8) d'un semiconducteur sur la structure obtenue en e),

   g) - déposer une couche (9) d'un premier isolant électrique sur la couche de semi-conducteur,

   h) - déposer une couche (10) d'un second matériau conducteur sur la couche de premier isolant,

   i) - photograver l'empilement des couches de second matériau conducteur, de premier isolant électrique et de semi-conducteur pour fixer les dimensions du transistor, et

   j) - passiver la structure obtenue en i) avec un second isolant électrique (12).

2. Procédé selon la revendication 1, caractérisé en ce que le second isolant électrique (12) est du carbone amorphe hydrogéné.

3. Procédé selon la revendication 1 ou 2, caractérisé en ce que la couche (6) de carbone amorphe déposée en d) a une épaisseur égale à l'épaisseur de la couche de premier matériau conducteur.

4. Procédé selon l'une quelconque des revendications 1 à 3, caractérisé en ce que le carbone amorphe hydrogéné est déposé à partir d'un plasma radiofréquence constitué essentiellement d'hydrocarbure.

5. Procédé selon la revendication 4, caractérisé en ce que le plasma est un plasma de méthane pur.

6. Procédé selon l'une quelconque des revendications 1 à 5, caractérisé en ce que le carbone amorphe hydrogéné est déposé à température ambiante.

7. Procédé selon l'une quelconque des revendications 1 à 6, caractérisé en ce qu'on utilise une tension d'autopolarisation du substrat inférieure à 55 volts.

8. Procédé selon l'une quelconque des revendications 1 à 7, caractérisé en ce que le substrat (1) est en verre.

9. Procédé selon l'une quelconque des revendications 1 à 8, caractérisé en ce que le semiconducteur (8) est du silicium amorphe hydrogéné.

**10.** Procédé selon l'une quelconque des revendications 1 à 9, caractérisé en ce que le carbone amorphe déposé présente une résistivité comprise entre $10^{12}$ et $10^{14}$ ohms.cm.

**11.** Procédé selon l'une quelconque des revendications 1 à 10, caractérisé en ce que le carbone amorphe hydrogéné est déposé en utilisant une pression d'hydrocarbure de 6,6 à 20Pa.

**Patentansprüche**

1. Verfahren zur Herstellung eines Transistors aus dünnen Schichten, welches darin besteht, daß
a) auf ein elektrisch isolierendes Trägermaterial (1) eine Schicht (2) aus einem leitfähigen Material aufgetragen wird,
b) auf die Schicht aus diesem leitfähigen Material Strukturen (3) aus lichtempfindlichem Harz aufgetragen werden, durch die die Strukturen festgelegt werden, welche in diese Schicht eingraviert werden sollen,
c) die Bereiche der Schicht aus diesem leitfähigen Material eliminiert werden, die nicht mit dem Harz bedeckt sind,
d) eine Schicht (6) aus amorphem, hydrierten Kohlenstoff auf die im Arbeitsgang c) erhaltene Struktur aufgebracht wird, wobei das Auftragen der Schicht bei einer ausreichend niedrigen Temperatur erfolgt, um das genannte Harz nicht zu beschädigen,
e) die Strukturen aus Harz aufgelöst werden, um den auf dem Harz aufgebrachten amorphen Kohlenstoff zu eliminieren,
f) eine Schicht (8) aus einem Halbleitermaterial auf die im Arbeitsgang e) erhaltene Struktur aufgebracht wird,
g) eine Schicht (9) aus einem elektrischen Nichtleitermaterial auf die Halbleiterschicht aufgebracht wird,
h) eine Schicht (10) aus einem weiteren leitfähigen Material auf die erste Isolierschicht aufgetragen wird,
i) die Abfolge der Schichten aus dem zweiten leitfähigen Material, dem ersten elektrisch isolierenden und dem Halbleitermaterial photograviert wird, um die Abmessungen des Transistors festzulegen und
j) die im Arbeitsgang i) erhaltene Struktur mit einem zweiten elektrischen Nichtleitermaterial (12) passiviert wird.

2. Verfahren nach Anspruch 1, dadurch gekennzeichnet, daß das zweite elektrische Nichtleitermaterial (12) aus amorphem, hydrierten Kohlenstoff besteht.

3. Verfahren nach Anspruch 1 oder 2, dadurch gekennzeichnet, daß die Schicht (6) aus amorphem Kohlenstoff, die im Arbeitsgang d) aufgetragen wurde, eine Stärke besitzt, die der Stärke der Schicht aus dem ersten leitenden Material entspricht.

4. Verfahren nach einem der Ansprüche 1 bis 3, dadurch gekennzeichnet, daß die Auftragung des amorphen, hydrierten Kohlenstoffs ausgehend von einem Radiofrequenzplasma erfolgt, das im wesentlichen aus Kohlenstoff gebildet wird.

5. Verfahren nach Anspruch 4, dadurch gekennzeichnet, daß das Plasma ein Plasma aus reinem Methan ist.

6. Verfahren nach einem der Ansprüche 1 bis 5, dadurch gekennzeichnet, daß die Auftragung des amorphen, hydrierten Kohlenstoffs bei Umgebungstemperatur erfolgt.

7. Verfahren nach einem der Ansprüche 1 bis 6, dadurch gekennzeichnet, daß eine vollautomatische Gitterspannung des Trägermaterials von unter 55 Volt verwendet wird.

8. Verfahren nach einem der Ansprüche 1 bis 7, dadurch gekennzeichnet, daß das Trägermaterial (1) aus Glas besteht.

9. Verfahren nach einem der Ansprüche 1 bis 8, dadurch gekennzeichnet, daß der Halbleiter (8) aus amorphem, hydrierten Silizium besteht.

**10.** Verfahren nach einem der Ansprüche 1-9, dadurch gekennzeichnet, daß der aufgetragene amorphe Kohlenstoff einen spezifischen Leitungswiderstand von $10^{12}$ bis $10^{14}$ Ohm/cm besitzt.

**11.** Verfahren nach einem der Ansprüche 1-10, dadurch gekennzeichnet, daß die Auftragung des amorphen, hydrierten Kohlenstoffs unter Anwendung eines Kohlenwasserstoffdruckes von 6,6 bis 20 Pa erfolgt.

**Claims**

**1.** Process for the production of a thin film transistor comprising:
a) depositing on an electrically insulating substrate (1) a layer (2) of a first conductive material,
b) producing photosensitive resin patterns (3) on the layer of the first conductive material defining the patterns to be etched in said layer,
c) eliminating the areas of the first conductive material layer not covered with resin,
d) depositing an amorphous hydrogenated carbon layer (6) on the structure obtained in c), said deposition taking place at a sufficiently low temperature to avoid a deterioration of said resin,
e) dissolving the resin patterns in order to eliminate the amorphous carbon deposited on the resin,
f) depositing a layer (8) of a semiconductor on the structure obtained in e),
g) depositing a layer (9) of a first electrical insulant on the semiconductor layer,
h) depositing a layer (10) of a second conductive material on the layer of the first insulant,
i) photoengraving the stack of layers of the second conductive material, the first electrical insulant and the semiconductor in order to fix the dimensions of the transistor and
j) passivating the structure obtained in i) with a second electrical insulant (12).

**2.** Process according to claim 1, characterized in that the second electrical insulant (12) is of amorphous hydrogenated carbon.

**3.** Process according to claim 1 or 2, characterized in that the amorphous carbon film (6) deposited in (d) has a thickness equal to that of the first conductive material film.

**4.** Process according to any one of the claims 1 to 3, characterized in that the amorphous hydrogenated carbon is deposited from a radio-frequency plasma essentially constituted by hydrocarbon.

**5.** Process according to claim 4, characterized in that the plasma is a pure methane plasma.

**6.** Process according to any one of the claims 1 to 5, characterized in that the amorphous hydrogenated carbon is deposited at ambient temperature.

**7.** Process according to any one of the claims 1 to 6, characterized in that use is made of a substrate self-bias voltage below 55 V.

**8.** Process according to any one of the claims 1 to 7, characterized in that the substrate (1) is of glass.

**9.** Process according to any one of the claims 1 to 8, characterized in that the semiconductor (8) is of amorphous hydrogenated silicon.

**10.** Process according to any one of the claims 1 to 9, characterized in that the deposited amorphous carbon has a resistivity between $10^{12}$ and $10^{14}$ ohms.cm.

**11.** Process according to any one of the claims 1 to 10, characterized in that the amorphous hydrogenated carbon is deposited using a hydrocarbon pressure of 6.6 to 20 Pa.

**FIG. 1a**

**FIG. 1b**

**FIG. 1c**

**FIG. 1d**

**FIG. 1e**

**FIG. 1f**

FIG. 2